**Europäisches Patentamt**

(19) **European Patent Office**

**Office européen des brevets**

(11) Publication number : **0 204 034 B1**

(12) # EUROPEAN PATENT SPECIFICATION

(45) Date of publication of patent specification :
**09.11.94 Bulletin 94/45**

(51) Int. Cl.[5] : **G11C 19/28**

(21) Application number : **85200590.9**

(22) Date of filing : **17.04.85**

(54) **Configurable logic array.**

(43) Date of publication of application :
**10.12.86 Bulletin 86/50**

(45) Publication of the grant of the patent :
**09.11.94 Bulletin 94/45**

(84) Designated Contracting States :
**DE FR GB**

(56) References cited :
**EP-A- 0 094 234**
**EP-A- 0 177 261**
**FR-A- 2 160 969**
**US-A- 3 431 433**
**US-A- 3 439 185**
**US-A- 3 564 514**
**US-A- 3 576 984**
**US-A- 3 990 045**
**C. MEAD and L. CONWAY: "INTRODUCTION TO VLSI-SYSTEMS", October 1980,pages 150-158; Addison-Wesley Publ., Reading US**

(56) References cited :
**INTERNATIONAL JOURNAL OF CONTROL, vol. 14, no. 6, December 1971, pages 1041-1061; London, GB B.S. RAJU et al. : "Programmable cellular arrays"**
**PROCEEDINGS OF THE INSTITUTION OF ELECTRICAL ENGINEERS, vol. 119, no- 7, July 1972, pages 785-789: Stevenage Herts, GB K.J. DEAN et al.: "Nonarithmetical cellular arrays."**

(73) Proprietor : **Xilinx, Inc.**
**2100 Logic Drive**
**San Jose, California 95124 (US)**

(72) Inventor : **Freeman, Ross H.**
**5667 McKellar Drive**
**San Jose California 95129 (US)**

(74) Representative : **Fieret, Johannes, Ir. et al**
**c/o Algemeen Octrooibureau**
**P.O.Box 645**
**NL-5600 AP Eindhoven (NL)**

## Description

BACKGROUND OF THE INVENTION

Field of the Invention

This invention relates to programmable logic arrays and in particular, to a method for providing on-chip programming of each of a plurality of logic elements formed on a chip of semiconductor material to configure each logic element to carry out certain desired functions.

Prior Art

Gate arrays are well known in the prior art. Typically a gate array is produced by interconnecting a plurality of active devices in a base array in any one of a number of ways to achieve a desired logic function. As gate arrays become more complex, the simulation of the logic to be achieved from a given interconnection of the active devices in the base array becomes more difficult and is typically carried out using a computer program. The layout of the actual interconnections for the active devices in the base array to yield a finished gate array is then derived using a computer aided design program of a type well known in the art. The process of designing such a structure is complex and reasonably expensive requiring the use of logic simulation and verification programs and semiconductor device layout programs. Accordingly, a need exists for an alternative approach which significantly simplifies the obtaining of a given logic function from a base array.

SUMMARY

A configurable logic array which allows changing the configuration of the finished integrated circuit from time-to-time (even when the integrated circuit is installed in a system) to provide any one of a plurality of logical functions from the same integrated circuit. By providing a number of "configurable logical elements" (also referred to herein as "logic elements") in the base array, a new type of integrated circuit is achieved which is capable of being configured to provide any one of a plurality of logic functions depending upon the tasks which the system of which it is a part is called upon to perform. By "configurable logical element" I mean a combination of devices which are capable of being electrically interconnected by switches operated in response to control bits to form any one of a plurality of logical functions.

A configurable logic array is comprised of a multiplicity of configurable logic elements each of which can include all the circuit elements necessary to provide one or more of the functions provided by an AND gate, flip flop, inverter, NOR gate, exclusive OR gate, and combinations of these functions to form more complex functions. The particular function to be carried out by a configurable logic element is determined by control signals applied to the configurable logic element from control logic. Depending on the control signals, the configurable logic element used in my invention can function as an AND gate, an OR gate, a NOR gate, a NAND gate or an exclusive OR gate or any one of a number of other logic elements without any change in physical structure. Structure is provided to allow any one of a plurality of functions to be selected from each configurable logic element. This is done by providing control logic to store and generate control signals which control the configuration of each configurable logic element.

In an embodiment the control signals are stored and transmitted by control logic formed integrally with and as part of the integrated circuit chip containing the configurable logic element. However, if desired the control information can be stored and/or generated outside this integrated circuit and transmitted through pins to the configurable logic element.

In general, a given set of control signals is transmitted to one configurable logic element to control the configuration of that configurable logic element. The control logic is thus arranged to provide any one set of a plurality of sets of control bits to each configurable logic element on the chip. The actual set of control bits provided to each configurable logic element on the integrated circuit chip depends on the function to be carried out by the integrated circuit chip or by each configurable logic element on the chip. The configuration of each logic element on the chip is determined by the intended function of the total chip and by the intended formation of that configurable logic element as part of the chip. Thus the resulting structure is known as a "Configurable Logic Array" or "CLA" and each logic element in the array is known as a "Configurable Logic Element" or "CLE".

In general, each integrated circuit chip has in addition to and associated with the control logic certain on-chip data routing circuitry. In an embodiment the on-chip data routing is achieved by using a memory to store the particular data used to configure the configurable logic elements and by then transferring the data from the memory to a combination of a dynamic shift register and static latch element within or associated with each

2

configurable logic element on the chip.

The particular structure used in this invention is versatile in that it can be implemented particularly easily using P channel, N channel, or CMOS technologies in the embodiment shown. Of course, structure incorporating the principles of this invention can, if desired, be implemented using any other appropriate semiconductor technology. The dynamic shift register-static latch element used in this invention is particularly useful in that the structural "overhead" (i.e., access circuitry and routing circuitry) is kept to a minimum relative to the useful logic functions on the total chip. Of particular importance, no addressing, data selection, or decoding in each configurable logic element is necessary when this combination of a dynamic shift register and static latch element is used to implement the configurable logic array used in my invention.

The object of the present invention is achieved by the features of Claim 1. Preferred embodiments and a method implementing the configurable logic array chip according to Claim 1 are specified by the features of Claims 8, 13, 15, and 21, respectively.

This invention as claimed in the attached claims will be more fully understood in conjunction with the following detailed description thereof taken together with the drawings.

Description of the Drawings

Figure 1 illustrates some of the various logic functions capable of being integrated in each logic element in a configurable logic array;

Figure 2 illustrates the internal logic structure of one possible logic element capable of implementing a number of useful functions with two variables A, B and certain configuration control bits, CO through C5;

Figure 3A illustrates a 16 bit RAM select circuit wherein any one of sixteen possible input states is capable of being identified and $2^{16}$ functions are capable of being implemented;

Figure 3B illustrates a selection structure for selecting any one of sixteen bits capable of implementing $2^{16}$ functions, for transmittal to an output lead;

Figure 3C illustrates one possible Karnaugh plot for the structure of Figure 3A;

Figure 3D illustrates the logic gates represented by placing a binary one in the Karnaugh map of Figure 3C at the intersections of the first and second rows and the first column.

Figure 4A illustrates an embodiment wherein a plurality of configurable logic elements (shown as nine logic elements) are formed on an integrated circuit chip together with programmable interconnects formed between selected leads to yield desired logic functions and with selected input/output pads and interconnections of the leads between logic elements;

Figure 4B shows the key to the cross-connections between crossing conductive leads in Figure 4B;

Figure 5 represents a portion of the circuitry of a combination static and dynamic shift register appropriate for use with the configurable logic array used in this invention;

Figures 6A through 6H represent wave forms of use in explaining the operation of the structure of Figure 5;

Figure 7A represents a schematic diagram of a configurable logic array showing nine of N configurable logic elements where N is a selected integer greater than 9 and selected interconnections between conductive leads;

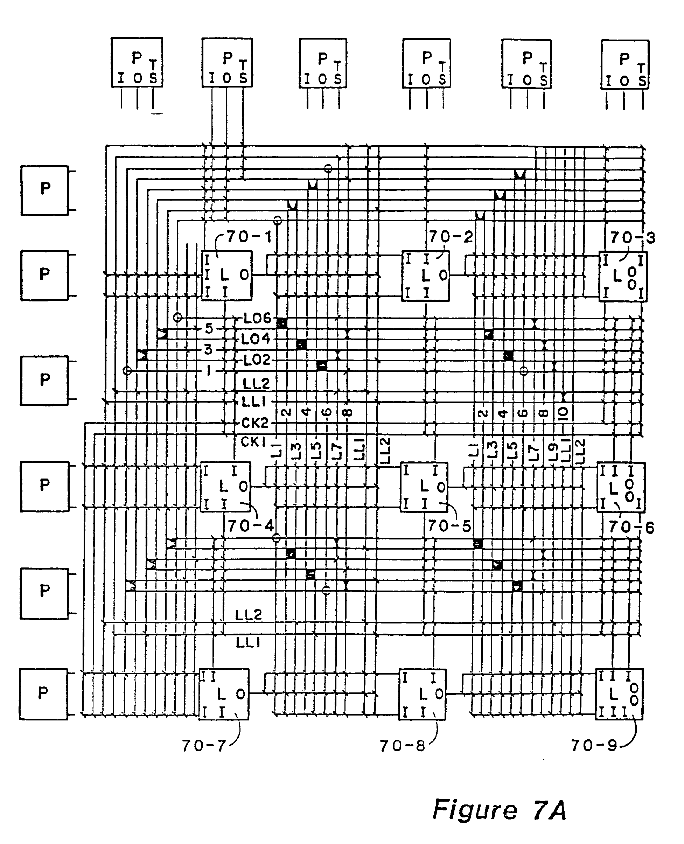

Figures 7B-1 through 7B-7 are the key showing the types of interconnections made by the symbols shown in Figure 7A;

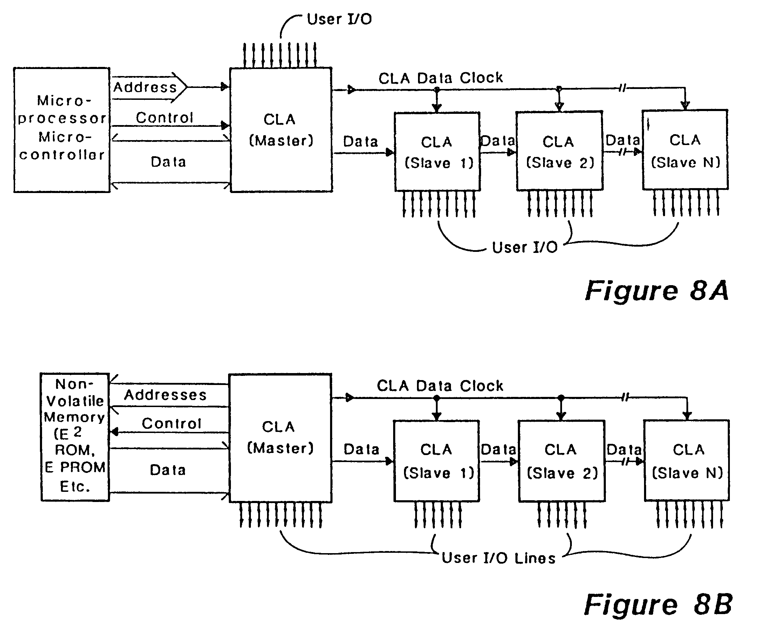

Figure 8A illustrates a system with a microprocessor controller and four configurable logic arrays;

Figure 8B illustrates a combination of four configurable logic arrays together with a nonvolatile memory; and

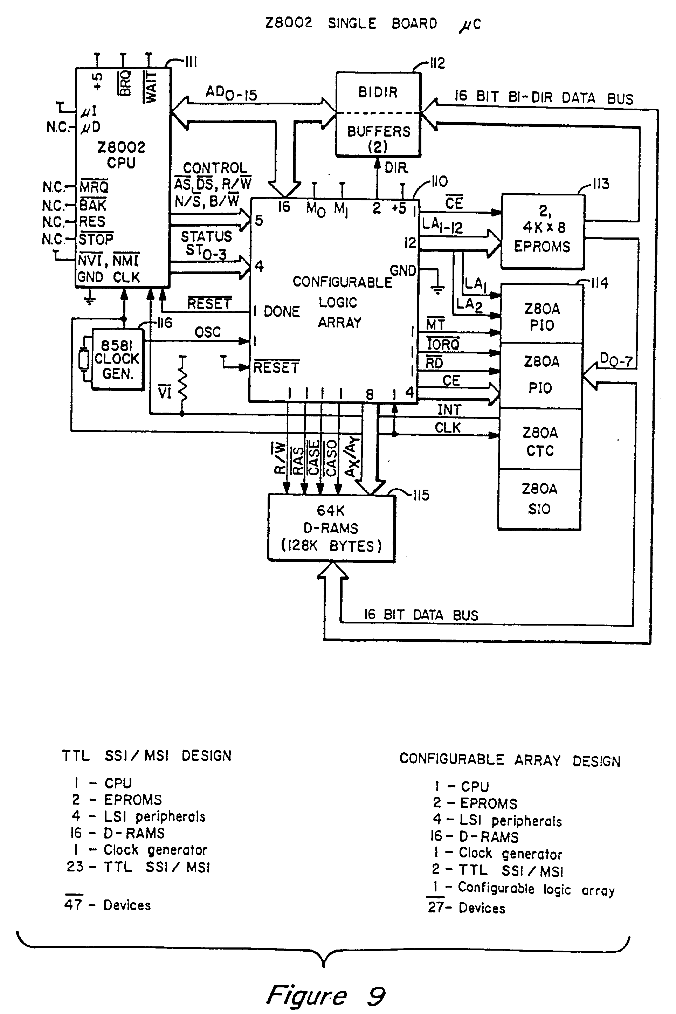

Figure 9 shows a single board microcomputer using the Configurable Logic Array of this invention.

BACKGROUND

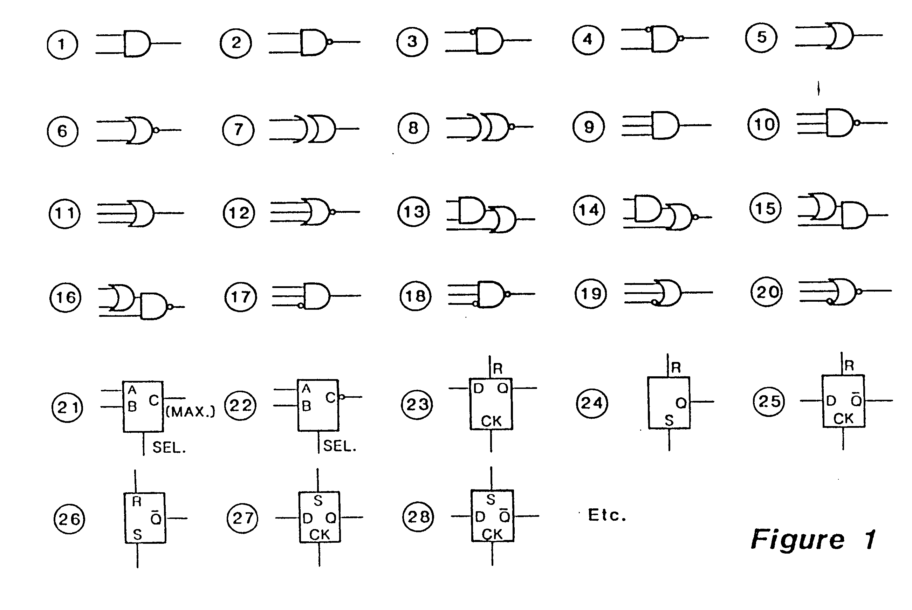

EP-A-0 177 261 representing the state of the art according to Art. 54(3), EPC, for all of the designated contracting states concerned will now be described in some detail by referring to Figures 1-7B of the drawings.

EP-A-0 177 261 discloses a configurable logic array chip comprising a plurality of configurable logic elements each comprising a combination of devices capable of being configured in response to configuration information to form any one of a plurality of logical functions, and a plurality of memory cells for holding configuration information, said configuration information configuring said configurable logic array chip.

Turning now to Figure 1, Figure 1 illustrates certain logic functions capable of being integrated into a configurable logic element. The 28 functions shown in Figure 1 are merely illustrative and other elements not shown can, if desired, be included in a configurable logic element, The following elements are shown:

| Element | Function |
|---------|----------|
| 1 | AND gate |
| 2 | NAND gate |
| 3 | AND gate with inverted input |
| 4 | NAND gate with inverted input |
| 5 | OR gate |
| 6 | NOR gate |
| 7 | exclusive OR gate |
| 8 | exclusive NOR gate |
| 9 | 3 input AND gate |
| 10 | 3 input NAND gate |
| 11 | 3 input OR gate |
| 12 | 3 input NOR gate |
| 13 | OR gate with one input comprising AND gate |
| 14 | NOR gate with one input comprising AND gate |
| 15 | AND gate with one input comprising OR gate |
| 16 | NAND gate with one input comprising OR gate |
| 17 | 3 input AND gate with one input inverted |
| 18 | 3 input NAND gate with one inverted input |
| 19 | 3 input OR gate with one inverted input |
| 20 | 3 lead NOR gate with one inverted input |
| 21 | one of two inputs multiplexer |
| 22 | inverting one of two inputs multiplexer |
| 23 | "D" flip flop with reset |
| 24 | Set-Reset latch |
| 25 | "D" flip-flop with reset and inverted output |
| 26 | Set-reset latch with reset and inverted output |
| 27 | "D" flip-flop with set |
| 28 | "D" flip-flop with set and inverted output |

Of course, other logic elements can also be implemented in accordance with this invention.

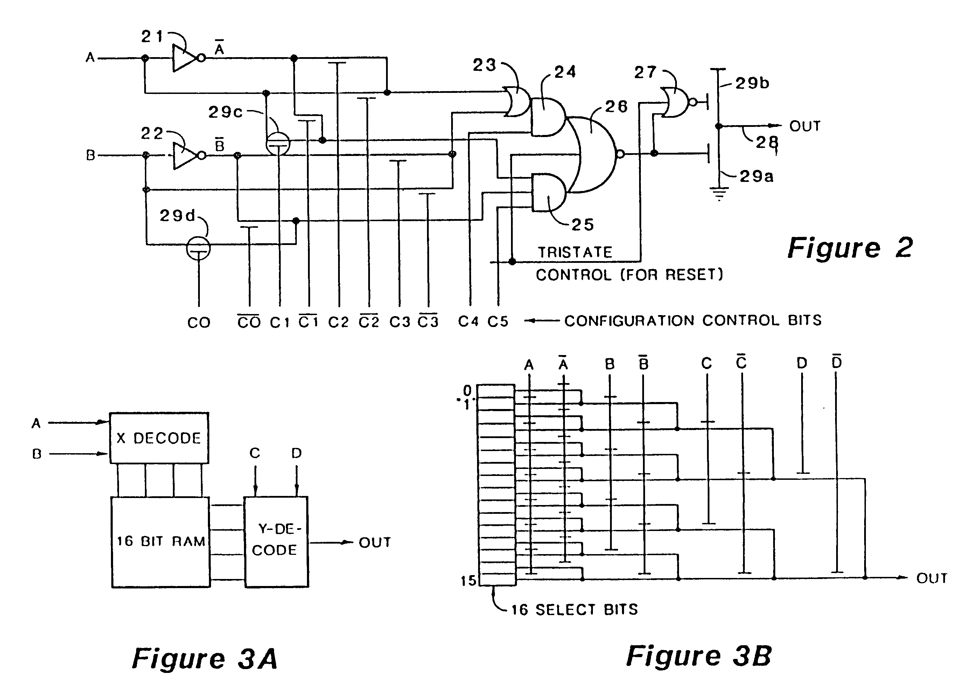

Figure 2 illustrates the internal logic structure of one possible logic element which is capable of implementing all useful functions of the two variables A and B, with the functions being selected by configuration control signals C0, $\overline{C0}$, C1, $\overline{C1}$... through C5, as shown in Figure 1. For example, to implement an AND gate function using the structure shown in Figure 2, the input leads labeled A and B are shunted past inverters 21 and 22, respectively, by high level signals on the C1 and C0 configuration control leads. Leads C1 and C0 are

4

connected to well-known pass transistors 29c and 29d. (Throughout this specification a pass transistor will be represented by the symbol shown within the circles 29c and 29d). Low level signals are applied to the configuration control leads $\overline{C0}$, $\overline{C1}$, C4. Assuming that C0, C1 and all of the other leads are connected to N channel MOS pass transistors, the control signals, C2, $\overline{C2}$, C3 and $\overline{C3}$ are "don't cares". That is, these signals can be high or low without affecting the output signal. In addition, a high level signal on C5 is applied to enable AND gate 25. The high level signal from AND gate 25 is passed through NOR gate 26. From NOR gate 26 this signal proceeds as a low level signal to turn off MOS transistor 29a (the source of which is grounded and the drain of which is connected to the output lead 28) and to turn on through NOR gate 27 N channel transistor 29b (the drain of which is connected to a power supply and the source of which is connected to both the output lead 28 and the drain of N channel transistor 29a). Thus the structure of Figure 2 configured as described above is an AND gate. Other logic functions can also be produced by appropriate selection of the control signals to be supplied to the configuration control leads C0 through C5 to activate the appropriate pass transistors and gates within the structure.

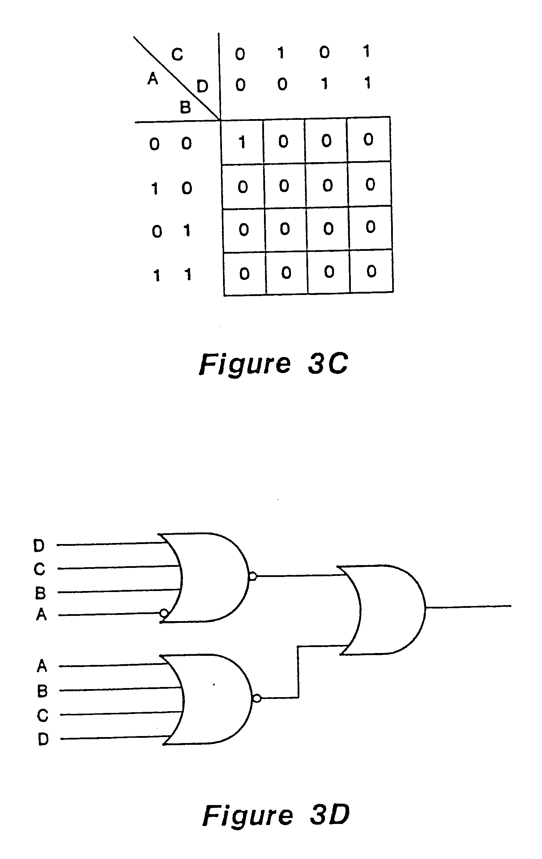

Figure 3A illustrates a 16 bit RAM capable of to producing an output signal in response to any one of sixteen possible combinations of input signals. Thus input signals A and B control the X decoder to select any one of the four columns in the 16 bit RAM. Input signals C and D control the Y decoder to select any one of the four rows in the 16 bit RAM. The 16 bit RAM produces an output signal representative of the bit at the intersection of the selected row and column. There are 16 such intersections and thus sixteen such bits. There are $2^{16}$ possible combinations of functions capable of being represented by 16 bits. Thus, if a NOR gate is to be simulated by the 16 bits in the RAM, the Karnough map for the RAM would be as shown in Figure 3C. In Figure 3C all bits are "0" except the bit at the intersection of the first row (representing A=0, B=0) and the first column (representing C=0, D=0). Should a less frequently used function be desired to be generated by the 16 bit RAM, (for example, should a "1" output signal be desired for A=1, B=0, C=0 and D=0) then a binary "1" is stored at the intersection of the second row and the first column. Should a binary "1" be desired both when A=0, B=0, C=0 and D=0 and also when A=1, B=0, C=0 and D=0, then a binary "1" is stored at each of the intersections of the first column with the first row and the second row. The logic circuit represented by this loading of the RAM is as shown in Figure 3D. Thus the RAM of Figure 3A represents an elegant and simple implementation of any one of $2^{16}$ logic functions.

Figure 3B shows another structure for yielding any one of sixteen select bits. Each of registers 0-15 in the vertical column to the left labelled "16 Select Bits", contains a selected signal, either a binary 1 or 0. By selecting the proper combination of A, B, C, and D, a particular bit stored in a particular one of the sixteen locations in the 16 Select Bits register is transmitted to the output lead. Thus, for example, to transmit the bit in the "1" register to the output lead, the signal A, B, C, D is applied to the leads so labeled. To transmit the signal labeled "15" in the sixteenth location in the 16 Select Bits register to the output lead, the signal A, $\overline{B}$, $\overline{C}$, and $\overline{D}$ is applied to the appropriate columns. Again, any one of $2^{16}$ logic functions can be implemented using this structure.

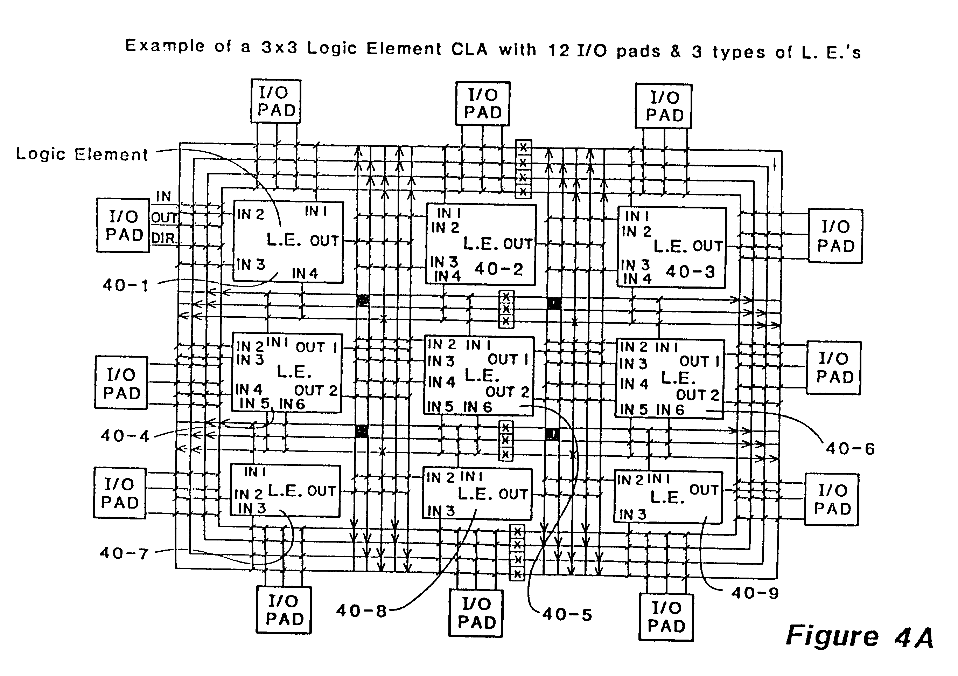

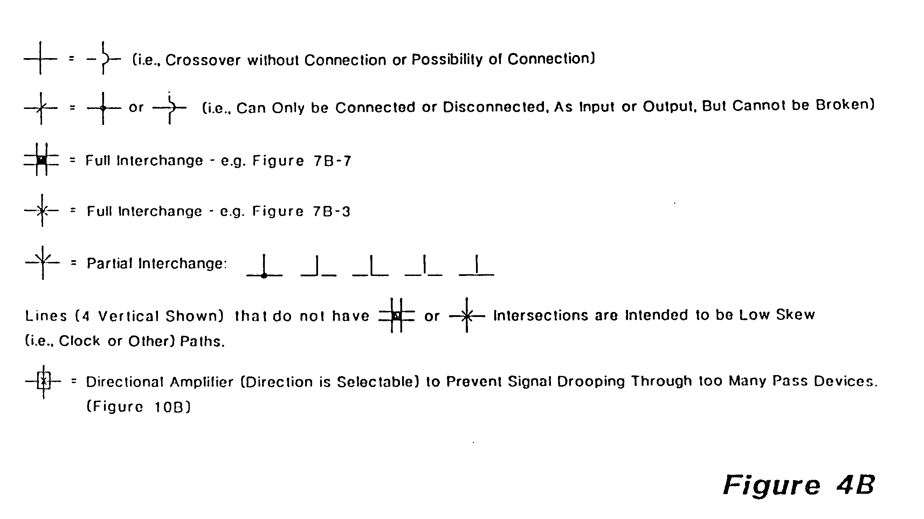

Figures 4A illustrates an embodiment of a configurable logic array containing nine configurable logical elements. As shown in Figure 4A, nine logical elements are placed on an integrated circuit chip together with interconnects and variable switches for connecting various leads to other leads. Each of logic elements 40-1 through 40-9 represents a collection of circuitry such as that shown in Figure 2 or some similar structure capable of being configured as described above in Figure 2 to perform any one of a number of logic functions. To program the circuitry, selected signals are applied to input leads identified as configuration control input leads thereby to generate a desired logical function in each of the logic elements. In Figure 4A, no specific lead has been identified as an input lead for the configuration control signals. However, any particular I/O pad can be selected for this purpose. The configuration control bids can be input into the configurable logic array either in series or in parallel depending upon design considerations. In addition, another I/O pad will be used on input clock signals to clock the logic elements both for the shifting in of the configuration control signals to each configurable logic element and for controlling the operation of each logic element during the. functioning of the integrated circuit chip in its intended manner. The combination of logic elements 40-1 through 40-9 yields the desired logical output for the configurable Logic Array. Figure 4B illustrates the meaning of the interconnect symbols used in Figure 4A.

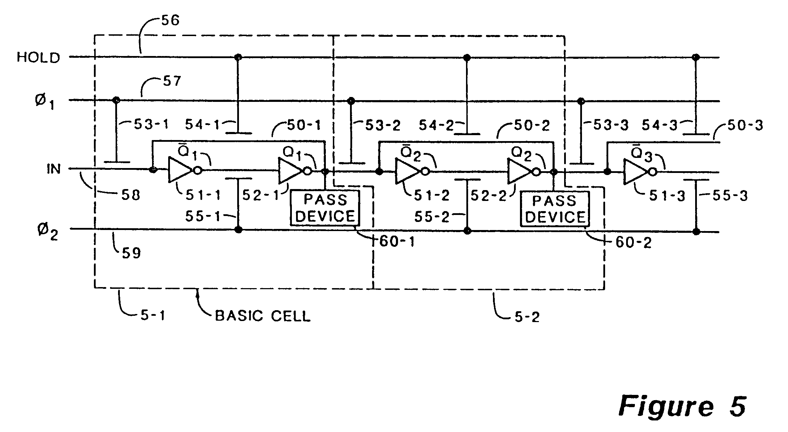

To configure a logic element such as logic element 40-1 (Figure 4A, 4B) a number of bits must be applied to the configuration control leads such as leads C0 through C5, as shown, for example, in Figure 2. To do this, a shift register is utilized, in an preferred embodiment, as part of each configurable logic element. Figure 5 illustrates a shift register of use in this invention. The shift register of Figure 5 is illustrated showing two basic storage cells. Each storage cell is capable of storing one bit of information. Of course, an actual shift register will contain as many storage cells as required to configure the logic element of which the shift register is a part, to its desired configuration. In operation, an input signal is applied to input lead 58. This input signal (shown in Figure 6D) contains the pulses to be stored in the shift register as configuration control bits to configure the configurable logic element to perform a desired logic function or to configure an interconnection between leads in a manner to be described shortly. Thus the sequence of pulses applied to input lead 58 represents those pulses which when stored in the storage cells of the shift register will activate the configuration control bits in the proper manner to achieve the desired functional and/or interconnection result. For example, if the circuit of Figure 2 is to be configured to form an AND gate, the pulses C0, C1, C2, C3, C4, and C5 would be represented by 1,1,X X, 0,1.

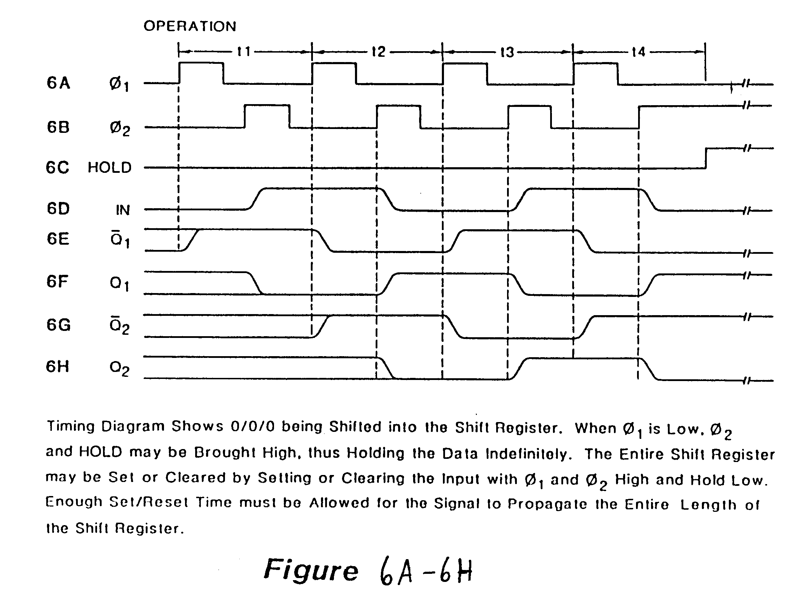

The sequence of pulses applied to input lead 58 is synchronized with clocking pulses $\phi$1 and $\phi$2 applied to leads 57 and 59 respectively. Thus in the first period of operation clocking pulse $\phi$1 goes high (Fig. 6A), clocking pulse $\phi$2 is low (Fig. 6B), the hold signal (Fig. 6C) is low during shifting thereby facilitating the passage of data through sequentially connected cells 5-1, 5-2 et al. of the shift register. To shift the pattern 01010 into the shift register, the following operations occur: The input signal on lead 58 is low during approximately the first half cycle of the clocking period t1. The output signal $\overline{Q1}$ of inverter 51-1 goes to a high level in response to the low level input signal and $\phi$1 high to enable PASS transistor 53-1. Come time through the first clocking period t1, the clock signal $\phi$1 goes low (Fig. 6A) and the clock signal $\phi$2 shortly thereafter goes high (Fig. 6B) to enable PASS transistor 55-1. Consequently, the high level output signal $\overline{Q1}$ is transmitted to the input lead of inverter 52-1 by enabled pass transistor 55-1 and thereby produces a low level output signal Q1 on the output lead of inverter 52-1. Thus at the end of period t1, the output signal Q1 (Figure 6F) from inverter 52-1 is low level. The output signals $\overline{Q2}$ and Q2 from inverters 51-2 and 52-2 in the second cell are still indeterminate because no known signal has yet propagated to the second storage cell 5-2 to change the signals of these inverters to a known state.

At the beginning of the second period (labeled "t2" in Fig. 6A), $\phi$1 goes high (Fig. 6A) and $\phi$2 is low (Fig. 6B) having gone low before period t1 ended. The input signal (Figure 6D) now has risen to a high level representing a binary 1 and thus the output signal $\overline{Q1}$ of inverter 51-1 has gone low. The output signal Q1 of inverter 52-1 remains low because pass transistor 55-1 is held off by the low level $\phi$2 signal. Some time through the second period $\phi$1 goes low followed a fraction of time later by $\phi$2 going high. At this time, the output signal $\overline{Q1}$ is transmitted through pass transistor 55-1 to inverter 52-1 thereby driving the output signal Q1 from inverter 52-1 to high level. Meanwhile, during period t2 the previous low level signal on Q1 has driven the output signal $\overline{Q2}$ of inverter 51-2 to a high level when Q1 was at a high level to enable PASS transistor 53-2 and the change in $\phi$2 from a low level to a high level in the second half of period t2 to enable PASS transistor 55-2 drives the output signal Q2 from inverter 52-2 to a low level. In this manner, the input signal on lead 58 (Fig. 6D) is transmitted through each of the cells 5-1, 5-2, 5-3 et al. in the shift register. Upon the transfer into the shift register of the desired information, the hold signal (Figure 6C) is enabled (i.e., driven to a high level) thereby to connect the feedback leads 50-1, 50-2, and 50-3 et al. from the output leads of inverters 52 to the input leads of inverters 51 so as to hold the information then in each cell indefinitely. In operation, the signal stored in a given cell 5 is connected to a configuration control or to an interconnect pass device.

The $\overline{Q}_1$, $Q_1$, $\overline{Q}_1$, $Q_2$, etc., of the shift register are directly connected to the (configuration) control inputs of a logic unit or the pass devices of the configurable interconnect.

When $\phi$1 is low, $\phi$2 and hold may be brought high, thus holding the data indefinitely. The entire shift register may be set or cleared by setting or clearing the input with $\phi$1 and $\phi$2 both high and HOLD low. Enough set/reset time must be allowed for the signal to propagate the entire length of the shift register to clear the shift register in this manner. Naturally this time is dependent upon the length of the shift register.

The shift register operates in its dynamic phase by storing the information being shifted as charge on the gates of the transistors (not shown in Figure 5 but well-known) comprising inverters 51-1, 52-1, 51-2, 52-2 et al. of the shift register. These inverters are of well-known design and will not be described in detail. The use of dynamic shift register is an important feature of the invention because a dynamic shift register uses six transistors and thus takes up very little area. Uniquely, the dynamic shift register is converted to a static latch by adding only one transistor. Thus the dynamic shift register-static latch can be easily fabricated as part of a configurable logic element without adding significant complexity to the circuit or consuming significant semiconductor area. Because of the "hold" signal, the dynamic shift register can be driven at a very low frequency because placing the shift register on hold automatically refreshes the data. Thus a separate refresh circuit is not needed.

It will be apparent from the above description that the dynamic shift register static latch circuit is unique in that it does not need refreshing once it has been latched into a hold position. This is accomplished by use of the feedback circuit comprising lead 50-1 and pass transistor 54-1 in cell 5-1, for example.

Figure 7A shows an additional configurable logic array containing a plurality of configurable logic elements. In particular, configurable logic elements 70-1, 70-2, 70-4 and 70-5 are shown in their entirety while configurable logic elements 70-3, 70-6 and 70-7 through 70-9 are shown partially. In particular, the complete interconnections of these last five logical elements are not shown. The structure shown in Figure 7A is merely illustrative of the types of configurations and connections which can be implemented using the configurable logic array of this invention and does not depict an actual circuit configured to carry out an intended function.

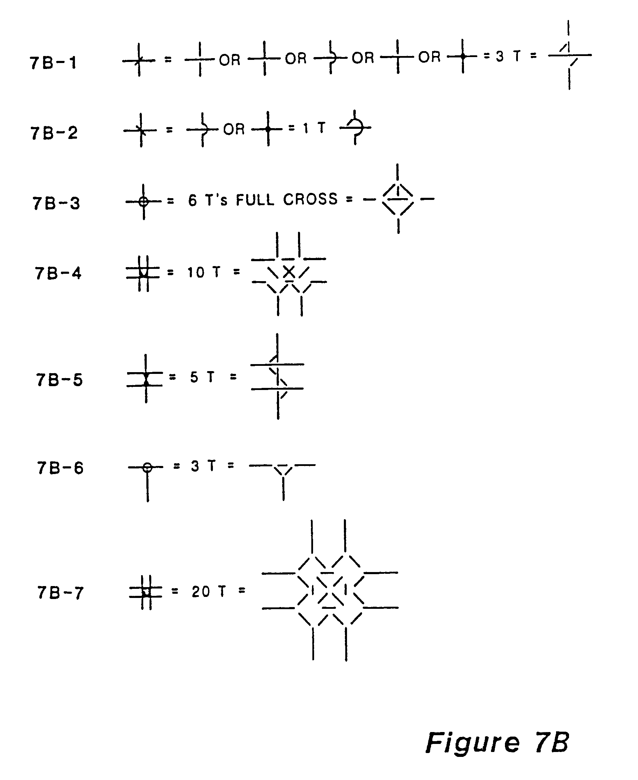

As shown in Figure 7A, given leads can be interconnected by any one of a plurality of different means (i.e., interconnection structures). The symbols representing the interconnections shown in Figure 7A are illustrated in Figure 7B. In particular, the schematics depicting various interconnections are to some extent self-explanatory.

For example, Figure 7B-2 illustrates a solid block involving a twenty pass transistor interchange. This particular twenty transistor interchange is shown in more detail in Figure 7B-7.

For convenience, Figure 7B-1 illustrates three transistors capable of making a T connection or a cross-connection but not a full interconnection. By full interconnection is meant the ability to connect each of the leads (in Figure 7B-1, four leads) coming into a node to a given node or to each of the other leads coming into the node in any combination.

Figure 7B-2 shows a one transistor interconnection to connect a row with a column. Figure 7B-3 shows a six transistor full cross interconnection wherein any one of four leads coming into a node can be connected to any one of the other three leads. Figure 7B-4 shows six leads coming into an intersection wherein ten pass transistors are used to interconnect any one of the six input leads to any one of the five other leads input to the node. Figure 7B-5 illustrates a four-lead node where two horizontal continuous leads are interconnected with two separate vertical leads using five pass transistors.

Figure 7B-6 illustrates a three-transistor interconnection wherein any one of three leads coming into a node can be interconnected with any one of the other two leads. Figure 7B-7 illustrates the twenty-transistor interchange for interconnecting any one of eight input leads to any one of the other eight input leads except that lead parallel and adjacent to the lead being interconnected and except for four interconnections which also cannot be directly made using the structure of Figure 7B-7.

## DETAILED DESCRIPTION OF THE INVENTION

Figures 8A and 8B illustrate two possible systems capable of using the configurable logic arrays of this invention. In Figure 8A, a microprocessor microcontroller produces address signals, control signals and data signals which are transmitted to a master configurable logic array. Also shown as N slave CLAs. As shown in Figure 8A, the control bits to control each of the configurable logic elements in each slave configurable logic array are transmitted on the data leads from the microcontroller to the master configurable logic array. From the master configurable logic array, this data is transmitted in series to each one of N configurable logic arrays where N is a selected integer. The control bits for controlling the configuration of each configurable logic element in each of the configurable logic arrays are transmitted in series through slave configurable logic array 1, slave configurable logic array 2 through to the Nth configurable array. The data is stored in serial shift registers as described above in conjunction with Figure 5. When the proper bits are located in the proper storage cells in each shift register, the hold signal shown in Figure 6C is raised to a high level thereby locking each data bit into the proper location in the corresponding shift register and thus configuring each configurable logic element in each configurable logic array. The data clock signals are applied on a separate lead to each configurable logic array as shown to clock in the control data.

The address arrow pointing to CLA (master) in Figure 8A merely indicates that the microprocessor has the ability to select a particular master configurable logic array for receipt of data from the microprocessor. In Figure 8B the master configurable logic array is capable going into the nonvolatile memory with addresses to select particular data to be retrieved from the memory to be used to configure each of the slave configurable logic arrays. In Figure 8A the microprocessor produces address signals which will go to off chip memory or to other circuitry (not shown).

In Figure 8B the structure is similar to that shown in Figure 8A except that a nonvolatile memory such as a ROM, EPROM or E$^2$PROM is used as the source for the configuration control bits to be transmitted into each of the configurable logic arrays. The structure of Figure 8B is unique in that when power is turned on or when a reset signal is applied to the master CLA, the master CLA initiates the transfer of the information for controlling the transfer of the information for controlling or configuring the Configurable Logic Array from the non-volatile memory to the master CLS and to the slave CLAs 1 to N. In this sense, the structure of Figure 8B is self-configuring in response to power on or a reset signal.

A single board microcomputer using a Configurable Logic Array of this invention is shown in Figure 9. Configurable Logic Array 110 performs the chip decode functions, the latching functions and the various special logic that is necessary to implement a single board microcomputer. The CLA has an output lead ("DONE") which is low from the time the power is turned on until the single board microcomputer is fully functional.

The first event that occurs when power is turned on is that the Configurable Logic Array 110 forces the Z8000 CPU 111 into the reset state. Reset forces the outputs of the CPU to be tri-stated (i.e., to go to high impedance level) which makes it possible for the Configurable Logic Array to use the control lines from the CPU 111 while it is being configured. The Configurable Logic Array 110 through a set of address lines (LA$_1$ - LA$_{12}$) addresses the EPROMS which are also used for the bootstrap of the microprocessor. In addition, the EPROMS have available in them configuration information for the CLA 110. The CLA 110 has signals which, during the self-loading time, are fixed high, fixed low so that particular bi-directional buffers 112 can be set in the correct direction for loading data from the EPROMS 113 to the Configurable Logic Array 110. Configurable Logic Array 110 then sequentially addresses locations in the EPROMS 113 which are read into the Configurable Logic Array 110 to configure the CLA 110. When array 110 is totally configured it then takes on its new functions and unlatches the done output which releases the reset line to the CPU 111. CPU 111 is then in control of the entire system. The decode used herein decodes the addresses from the CPU to create chip enables and chip selects for the various RAMS and EPROMS in the system and for the I/O devices as well.

In Figure 4A directional amplifiers (shown by an X in a box) are used to amplify signals which have been attenuated by a number of pass transistors. This speeds up considerably the operation of the circuit. The delay of a signal increases approximately in proportion to the square of the number of pass transistors through which a signal must pass. The amplifer brings the signal voltage back to its normal level.

In view of the above description, it will be obvious to those skilled in the art that a configurable logic element in a Configurable Logic Array is capable of being reconfigured even after the Configurable Logic Array has been installed in a circuit. Indeed, this is one of the key advantages of the Configurable Logic Array of this invention. Thus, a configurable Logic Array can be reconfigured to provide a new logical function as part of its normal operation in the system of which it is a part.

Another advantage of this invention is that the I/O pads can be used as either input or output pads and can connect to any internal signal using pass transistors.

## Claims

1. A configurable logic array chip (Fig. 9, 110; Fig. 4A; Fig. 7A; Fig. 8A, 8B, Master, Slave) comprising:

   a plurality of configurable logic elements each comprising a combination of devices capable of being configured in response to configuration information to form any one of a plurality of logical functions;

   a plurality of memory cells (Fig. 5: 5-1, 5-2) for holding configuration information, said configuration information configuring said configurable logic array chip; and

   means (Fig. 9: LA$_{1-12}$ or AD$_{0-15}$) for selecting configuration information from a device (Fig. 9: 113 or 111) external to said configurable logic array chip and initiating (DONE) the transfer of said configuration information into said memory cells from said device (Fig. 9: 113 or 111) external to said configurable array chip.

2. A configurable logic array chip as in claim 1 in which said means for selecting and initiating initiates said transfer of said configuration information in response to said configurable logic array chip being powered up.

3. A configurable logic array chip as in claim 1 in which said means for selecting and initiating initiates said transfer of said configuration information in response to said configurable logic array chip being reset.

4. A system for configuring a logic array chip comprising:

   said configurable logic array chip (110) as in claim 1; and

   off-chip means (113) for storing said configuration information.

5. A system for configuring a logic array chip as in claim 4 in which said means for storing said configuration information comprises a nonvolatile memory device (113).

6. A system for configuring a logic array chip as in claim 5 further including means for loading said configuration information as a serial bit stream (D$_{0-7}$, 112, AD$_{0-15}$).

7. A system for configuring a logic array chip as in claim 5 further including means (D$_{0-7}$, 112, AD$_{0-15}$) for loading said configuration information in parallel.

8. A system for configuring a logic array chip comprising a configurable logic array chip (Fig. 8A or 8B; CLA Master) as in claim 1 and further comprising second means not part of said configurable logic array chip (Fig. 8A: microprocessor) for initiating the transfer of said configuration information into said memory cells.

9.  A system for configuring a logic array chip as in claim 8 in which said second means comprises a microprocessor.

10. A system for configuring a logic array chip as in claim 9 further comprising means for storing said configuration information (EPROM).

11. A system for configuring a logic array chip as in claim 10 in which said means for storing said configuration information comprises a nonvolatile memory (EPROM).

12. A system for configuring a logic array chip as in claim 9 in which said microprocessor provides control, address, and data information to said means for being configured.

13. A system for configuring a logic array chip comprising a first configurable logic array chip as in claim 1 and further comprising:
    a second configurable logic array chip (Slave) comprising means for holding information in memory cells, said inforamtion in said memory cells configuring said second configurable logic array chip; and
    means for passing configuration information from said first configurable logic array chip to said second configurable logic array chip (figs. 8A, 88: Data and Data Clock; fig. 5).

14. A system for configuring a logic array chip as in claim 13 in which said means for passing comprises a shift register (fig. 5).

15. A system (Figs. 8A, 8B) for configuring a logic array chip comprising:
    a first configurable logic array chip as in claim 1 (Master or Slave 1);
    means (Microprocessor, EPROM or Master) for loading configuration information into said first configurable logic array chip;
    a second configurable logic array chip (Slave 1 or Slave 2); and
    said first configurable logic array chip including means (Data) for loading configuration information into said second configurable logic array chip (Slave 1 or Slave 2).

16. A system for configuring a logic array chip as in claim 15 in which said means for loading configuration information into said first configurable logic array chip is a microprocessor (fig. 8A).

17. A system for configuring a logic array chip as in claim 16 in which said microprocessor (Fig. 9: 111) has access to a storage device (113) for holding said configuration information.

18. A system for configuring a logic array chip as in claim 15 in which said means for loading configuration information into said first configurable logic array chip (fig. 8a: Slave 1) is a third configurable logic array chip (fig. 8A: Master).

19. A system for configuring a logic array chip as in claim 15 further comprising said second configurable logic array chip (Slave 1) connected so as to receive said configuration information from said first configurable logic array chip (Master).

20. A system for configuring a logic array chip as in claim 19 in which said first and second configurable logic array chips include means (figs. 2, 3A, 3B) for being configured by said configuration information.

21. A method for configuring a configurable logic array chip (110) as in claim 1 having means for loading configuration information into said configurable logic array chip ($AD_{0-15}$) which is functionally interconnected with means (111) for operating said configurable logic array chip, said method comprising the steps of:
    connecting to said configurable logic array chip (110) means (112) for taking data from a supplier (113) of configuration information;
    disabling (DONE) said means for operating said configurable logic array chip;
    sequentially taking said information ($LA_{1-12}$) from said supplier (113) of configuration information; and
    enabling (DONE) said means for operating said configurable logic array chip.

22. A method for configuring as in claim 21 comprising the further step, performed between disabling and enabling said means for operating, of passing some of said information from said configurable logic array chip (fig. 8A:Master) to another configurable logic array chip (Slave 1).

23. A method for configuring as in claim 21 in which said step of connecting means for taking said information from said supplier of configuration information comprises the further steps of connecting leads from said configurable logic array chip (110) to means (112) for controlling direction on a bus such that initial direction of said bus is established for allowing data to flow from said supplier of information (113) to said configurable logic array chip (110).

24. A method for configuring as in claim 21 in which said step of sequentially taking said information from said supplier (113) of information comprises sequentially addressing said supplier of information with a counter (12) which is part of said configurable logic array chip (110).

**Patentansprüche**

1. Konfigurierbarer Logikarray-Chip (Fig. 9, 110; Fig. 4A; Fig. 7A; Fig. 8A, 8B, Master, Slave), mit:
   einer Vielzahl von konfigurierbaren Logikelementen, von denen jedes eine Kombination von Einrichtungen enthält, die im Ansprechen auf eine Konfigurations-Information konfigurierbar sind, um irgendeine aus einer Vielzahl von logischen Funktionen zu bilden;
   einer Vielzahl von Speicherzellen (Fig. 5: 5-1, 5-2) zum Halten von Konfigurations-Information, wobei die Konfigurations-Information den konfigurierbaren Logikarray-Chip konfiguriert; und
   einer Einrichtung (Fig. 9: $LA_{1-12}$ oder $AD_{0-15}$) zum Wählen von Konfigurations-Information aus einer Einrichtung (Fig. 9: 113 oder 111) außerhalb des konfigurierbaren Logikarray-Chips und zum Einleiten (DONE) der Übertragung der Konfigurations-Information in die Speicherzellen aus der Einrichtung (Fig. 9: 113 oder 111) außerhalb des konfigurierbaren Array-Chips.

2. Konfigurierbarer Logikarray-Chip nach Anspruch 1, bei dem die Einrichtung zum Wählen und Einleiten die Übertragung der Konfigurations-Information im Ansprechen darauf einleitet, wenn die Stromversorgung des konfigurierbaren Logikarray-Chips begonnen wird.

3. Konfigurierbarer Logikarray-Chip nach Anspruch 1, bei dem die Einrichtung zum Wählen und Einleiten die Übertragung der Konfigurations-Information im Ansprechen auf das Rücksetzen des konfigurierbaren Logikarray-Chips einleitet.

4. System zum Konfigurieren eines Logikarray-Chips mit:
   dem konfigurierbaren Logikarray-Chip (110) nach Anspruch 1; und
   einer außerhalb des Chips befindlichen Einrichtung (113) zum Speichern der Konfigurations-Information.

5. System zum Konfigurieren eines Logikarray-Chips nach Anspruch 4, bei dem die Einrichtung zum Speichern der Konfigurations-Information eine nichtflüchtige Speichereinrichtung (113) aufweist.

6. System zum Konfigurieren eines Logikarray-Chips nach Anspruch 5, das weiterhin eine Einrichtung zum Laden der Konfigurations-Information als ein serieller Bitstrom ($D_{0-7}$, 112, $AD_{0-15}$) umfaßt.

7. System zum Konfigurieren eines Logikarray-Chips nach Anspruch 5, das weiterhin eine Einrichtung ($D_{0-7}$, 112, $AD_{0-15}$) zum parallelen Laden der Konfigurations-Information umfaßt.

8. System zum Konfigurieren eines Logikarray-Chips, das einen konfigurierbaren Logikarray-Chip (Fig. 8A oder 8B; CLA Master) nach Anspruch 1 aufweist und das darüberhinaus eine zweite Einrichtung zum Einleiten der Übertragung der Konfigurations-Information in die Speicherzellen aufweist, die nicht Teil des konfigurierbaren Logikarray-Chips (Fig. 8A: Mikroprozessor) ist.

9. System zum Konfigurieren eines Logikarray-Chips nach Anspruch 8, bei dem die zweite Einrichtung einen Mikroprozessor aufweist.

10. System zum Konfigurieren eines Logikarray-Chips nach Anspruch 9, das weiterhin eine Einrichtung zum Speichern der Konfigurations-Information (EPROM) aufweist.

**11.** System zum Konfigurieren eines Logikarray-Chips nach Anspruch 10, bei dem die Einrichtung zum Speichern der Konfigurations-Information einen nichtflüchtigen Speicher (EPROM) aufweist.

**12.** System zum Konfigurieren eines Logikarray-Chips nach Anspruch 9, bei dem der Mikroprozessor der zu konfigurierenden Einrichtung Steuer-, Adress- und Daten-Informationen liefert.

**13.** System zum Konfigurieren eines Logikarray-Chips, das einen ersten konfigurierbaren Logikarray-Chip nach Anspruch 1 aufweist und weiterhin aufweist:

einen zweiten konfigurierbaren Logikarray-Chip (Slave) mit einer Einrichtung zum Halten von Information in Speicherzellen, wobei die Information in den Speicherzellen den zweiten konfigurierbaren Logikarray-Chip konfiguriert; und

eine Einrichtung zum Übertragen der Konfigurations-Information vom ersten konfigurierbaren Logikarray-Chip zum zweiten konfigurierbaren Logikarray-Chip (Figuren 8A, 8B: Data und Data Clock; Fig. 5).

**14.** System zum Konfigurieren eines Logikarray-Chips nach Anspruch 13, bei dem die Einrichtung zum Übertragen ein Schieberegister (Fig.5) aufweist.

**15.** System (Figuren 8A, 8B) zum Konfigurieren eines Logikarray-Chips, mit:

einem ersten konfigurierbaren Logikarray-Chip nach Anspruch 1 (Master oder Slave 1);

einer Einrichtung (Mikroprozessor, EPROM oder Master) zum Laden von Konfigurations-Information in den ersten konfigurierbaren Logikarray-Chip;

einem zweiten konfigurierbaren Logikarray-Chip (Slave 1 oder Slave 2);

wobei der erste konfigurierbare Logikarray-Chip eine Einrichtung (Data) zum Laden von Konfigurations-Information in den zweiten konfigurierbaren Logikarray-Chip (Slave 1 oder Slave 2) aufweist.

**16.** System zum Konfigurieren eines Logikarray-Chips nach Anspruch 15, bei dem die Einrichtung zum Laden von Konfigurations-Information in den ersten konfigurierbaren Logikarray-Chip ein Mikroprozessor (Fig. 8A) ist.

**17.** System zum Konfigurieren eines Logikarray-Chips nach Anspruch 16, bei dem der Mikroprozessor (Fig. 9: 111) Zugriff zu einer Speichereinrichtung (113) zum Halten der Konfigurations-Information hat.

**18.** System zum Konfigurieren eines Logikarray-Chips nach Anspruch 15, bei dem die Einrichtung zum Laden von Konfigurations-Information in den ersten konfigurierbaren Logikarray-Chip (Fig. 8a: Slave 1) ein dritter konfigurierbarer Logikarray-Chip (Fig. 8A: Master) ist.

**19.** System zum Konfigurieren eines Logikarray-Chips nach Anspruch 15, das weiterhin den zweiten konfigurierbaren Logikarray-Chip (Slave 1) aufweist, der zum Empfang der Konfigurations-Information aus dem ersten konfigurierbaren Logikarray-Chip (Master) verbunden ist.

**20.** System zum Konfigurieren eines Logikarray-Chips nach Anspruch 19, bei dem der erste und zweite konfigurierbare Logikarray-Chip Einrichtungen (Figuren 2, 3A, 3B) aufweisen, die zum Konfigurieren durch die Konfigurations-Information vorgesehen sind.

**21.** Verfahren zum Konfigurieren eines konfigurierbaren Logikarray-Chips (110) nach Anspruch 1, der eine Einrichtung zum Laden von Konfigurations-Information in den konfigurierbaren Logikarray-Chip ($AD_{0-15}$) aufweist, die funktionell mit einer Einrichtung (111) zum Betreiben des konfigurierbaren Logikarray-Chips zwischenverbunden ist, wobei das Verfahren folgende Schritte aufweist:

Verbinden des konfigurierbaren Logikarray-Chips (110) mit einer Einrichtung (112) zum Übernehmen von Daten aus einer Liefereinrichtung (113) von Konfigurations-Information;

Sperren (DONE) der Einrichtung zum Betreiben des konfigurierbaren Logikarray-Chips;

sequentielles Übernehmen der Information ($LA_{1-12}$) aus der Liefereinrichtung (113) von Konfigurations-Information; und

Freigeben (DONE) der Einrichtung zum Betreiben des konfigurierbaren Logikarray-Chips.

**22.** Verfahren zum Konfigurieren nach Anspruch 21, das den weiteren, zwischen dem Sperren und Freigeben der Einrichtung zum Betreiben durchgeführten Schritt der Übergabe eines Teils der Information aus dem konfigurierbaren Logikarray-Chip (Fig. 8A: Master) zu einem weiteren konfigurierbaren Logikarray-Chip (Slave 1) umfaßt.

23. Verfahren zum Konfigurieren nach Anspruch 21, bei dem der Schritt des Verbindens der Einrichtung zur Übernahme der Information aus der Liefereinrichtung von Konfigurations-Information die weiteren Schritte des Verbindens von Leitungen aus dem konfigurierbaren Logikarray-Chip (110) mit einer Einrichtung (112) aufweist, um die Richtung auf einem Bus derart zu steuern, daß die Anfangsrichtung des Busses so eingerichtet wird, daß es den Daten ermöglicht wird, aus der Liefereinrichtung von Information (113) zu dem konfigurierbaren Logikarray-Chip (110) zu fließen.

24. Verfahren zum Konfigurieren nach Anspruch 21, bei dem der Schritt der sequentiellen Übernahme der Information aus der Liefereinrichtung (113) von Information das sequentielle Adressieren der Liefereinrichtung von Information mit einem Zähler (12) umfaßt, der Teil des konfigurierbaren Logikarray-Chips (110) ist.

## Revendications

1. Réseau logique configurable intégré sur un micro-circuit (fig. 9, 110 ; fig. 4A ; fig. 7A; fig. 8A, 8B, Maître, Esclave) comprenant :
   - une pluralité d'éléments logiques configurables comprenant chacun une combinaison de dispositifs pouvant être configurés en réponse à une information de configuration pour former l'une quelconque des fonctions logiques parmi une pluralité ;
   - une pluralité de cellules mémoires (fig. 5 : 5-1, 5-2) permettant de maintenir une information de configuration, ladite information de configuration permettant de configurer ledit réseau logique configurable intégré ; et
   - des moyens (fig. 9 : $LA_{1-12}$ ou $AD_{0-15}$) de sélection d'une information de configuration dans un dispositif (fig. 9: 113 ou 111) externe audit réseau logique configurable intégré et d'initialisation (DONE) du transfert de ladite information de configuration dans lesdites cellules mémoires à partir dudit dispositif (fig. 9 : 113 ou 111) externe audit réseau logique configurable intégré.

2. Réseau logique configurable intégré selon la revendication 1 dans lequel lesdits moyens de sélection et d'initialisation initialisent ledit transfert de l'information de configuration en réponse à la mise sous tension dudit réseau logique configurable intégré.

3. Réseau logique configurable intégré selon la revendication 1 dans lequel lesdits moyens de sélection et d'initialisation initialisent ledit transfert de l'information de configuration en réponse à la remise à l'état initial dudit réseau logique configurable intégré.

4. Système de configuration d'un réseau logique intégré sur un microcircuit comprenant : ledit réseau logique configurable intégré (110) selon la revendication 1; et des moyens (113) hors microcircuit de stockage de ladite information de configuration.

5. Système de configuration d'un réseau logique intégré selon la revendication 4, dans lequel lesdits moyens de stockage de ladite information de configuration comprennent un dispositif à mémoire non volatile (113).

6. Système de configuration d'un réseau logique intégré selon la revendication 5, incluant également des moyens de chargement de ladite information de configuration sous la forme d'un train de bits série ($D_{0-7}$, 112, $AD_{0-15}$).

7. Système de configuration d'un réseau logique intégré selon la revendication 5, incluant également des moyens de chargement de ladite information de configuration en parallèle ($D_{0-7}$, 112, $AD_{0-15}$).

8. Système de configuration d'un réseau logique intégré comprenant un réseau logique configurable intégré (fig. 8A ou 8B, CLA Maître) selon la revendication 1 et comprenant également des seconds moyens ne faisant pas partie dudit réseau logique configurable intégré (fig. 8A : microprocesseur) et permettant d'initialiser le transfert de ladite information de configuration dans les cellules mémoires.

9. Système de configuration d'un réseau logique intégré selon la revendication 8, dans lequel lesdits se-

EP 0 204 034 B1

conds moyens comprennent un microprocesseur.

10. Système de configuration d'un réseau logique intégré selon la revendication 9, comprenant également des moyens de stockage de ladite information de configuration (EPROM).

11. Système de configuration d'un réseau logique intégré selon la revendication 10, dans lequel lesdits moyens de stockage de ladite information de configuration comprennent une mémoire non volatile (EPROM).

12. Système de configuration d'un réseau logique intégré selon la revendication 9, dans lequel ledit microprocesseur fournit des informations de données, d'adresses et de contrôle auxdits moyens devant être configurés.

13. Système de configuration d'un réseau logique intégré comprenant un réseau logique configurable intégré selon la revendication 1 et comprenant également :
   - un second réseau logique configurable intégré (Esclave) comprenant des moyens de maintien d'une information dans les cellules mémoires, ladite information dans lesdites cellules mémoires configurant ledit second réseau logique configurable intégré ; et
   - des moyens de passage de l'information de configuration du premier réseau logique configurable intégré vers le second réseau logique configurable intégré (figs. 8A, 8B : Données et Horloge de Données; fig. 5).

14. Système de configuration d'un réseau logique intégré selon la revendication 13, dans lequel lesdits moyens de passage comprennent un registre à décalage (fig. 5).

15. Système (figs. 8A, 8B) de configuration d'un réseau logique intégré comprenant :
   - un premier réseau logique configurable intégré selon la revendication 1 (Maître ou Esclave 1) ;
   - des moyens (Microprocesseur, EPROM ou Maître) de chargement de l'information de configuration dans ledit premier réseau logique configurable intégré ;
   - un second réseau logique configurable intégré (Esclave 1 ou Esclave 2) ; et
   - ledit premier réseau logique configurable intégré incluant des moyens (Données) de chargement de l'information de configuration dans ledit second réseau logique configurable intégré (Esclave 1 ou Esclave 2).

16. Système de configuration d'un réseau logique intégré selon la revendication 15, dans lequel lesdits moyens de chargement de l'information de configuration dans ledit premier réseau logique configurable intégré est un microprocesseur (fig. 8A).

17. Système de configuration d'un réseau logique intégré selon la revendication 16, dans lequel ledit microprocesseur (fig. 9 : 111) a accès à un dispositif de stockage (113) afin de maintenir ladite information de configuration.

18. Système de configuration d'un réseau logique intégré selon la revendication 15, dans lequel lesdits moyens de chargement de l'information de configuration dans ledit premier réseau logique configurable intégré (fig. 8A : Esclave 1) sont un troisième réseau logique configurable intégré (fig. 8A : Maître).

19. Système de configuration d'un réseau logique intégré selon la revendication 15, comprenant également ledit second réseau logique configurable intégré (Esclave 1) connecté de façon à recevoir ladite information de configuration provenant dudit premier réseau logique configurable intégré (Maître).

20. Système de configuration d'un réseau logique intégré selon la revendication 19, dans lequel lesdits premier et second réseau logiques configurables intégrés incluent des moyens (figs. 2, 3A, 3B) pour être configurés par ladite information de configuration.

21. Procédé de configuration d'un réseau logique configurable intégré (110) selon la revendication 1 possédant des moyens de chargement d'une information de configuration dans ledit réseau logique configurable intégré ($AD_{0-15}$) qui sont interconnectés fonctionnellement avec des moyens (111) de commande dudit réseau logique configurable intégré, ledit procédé comprenant les étapes de :
   - connexion audit réseau logique configurable intégré (110) de moyens (112) de saisir des données dans un fournisseur (113) d'information de configuration ;

13

- invalidation (DONE) desdits moyens de commande dudit réseau logique configurable intégré ;
- prise séquentielle de ladite information ($LA_{1-12}$) dans ledit fournisseur (113) d'information de configuration ; et
- validation (DONE) desdits moyens de commande dudit réseau logique configurable intégré.

22. Procédé de configuration selon la revendication 21, comprenant également l'étape, exécutée entre l'invalidation et la validation desdits moyens de commande, de passage d'une partie de ladite information dudit réseau logique configurable intégré (fig. 8A : Maître) vers un autre réseau logique configurable intégré (Esclave 1).

23. Procédé de configuration selon la revendication 21, dans lequel ladite étape de connexion de moyens de saisir ladite information dans ledit fournisseur d'information de configuration comprend les autres étapes de connexion de câbles entre ledit réseau logique configurable intégré et des moyens (112) de contrôle d'une direction sur un bus, de façon que la direction initiale dudit bus soit établie pour permettre aux données de passer dudit fournisseur d'information (113) vers ledit réseau logique configurable intégré (110).

24. Procédé de configuration selon la revendication 21, dans lequel ladite étape de prise séquentielle de ladite information dans ledit fournisseur (113) d'information comprend un adressage séquentiel dudit fournisseur d'information avec un compteur (12) qui fait partie dudit réseau logique configurable intégré (110).

Figure 1

Figure 2

Figure 3A

Figure 3B

*Figure 3C*

*Figure 3D*

Example of a 3×3 Logic Element CLA with 12 I/O pads & 3 types of L. E.'s

Figure 4A

$+$ = $-\rangle-$ (i.e., Crossover without Connection or Possibility of Connection)

$-+-$ = $-+-$ or $-\rangle-$ (i.e., Can Only be Connected or Disconnected, As Input or Output, But Cannot be Broken)

$\#$ = Full Interchange - e.g. Figure 7B-7

$-*-$ = Full Interchange - e.g. Figure 7B-3

$-*-$ = Partial Interchange: $\perp$ $\rfloor\_$ $\_\llcorner$ $\_\lfloor$ $\_\lfloor$

Lines (4 Vertical Shown) that do not have $\#$ or $-*-$ Intersections are Intended to be Low Skew (i.e., Clock or Other) Paths.

$-\boxtimes-$ = Directional Amplifier (Direction is Selectable) to Prevent Signal Drooping Through too Many Pass Devices. (Figure 10B)

*Figure 4B*

EP 0 204 034 B1

*Figure 5*

EP 0 204 034 B1

OPERATION

| 6A | $\emptyset_1$ |
| 6B | $\emptyset_2$ |
| 6C | HOLD |
| 6D | IN |
| 6E | $\bar{Q}_1$ |
| 6F | $Q_1$ |
| 6G | $\bar{Q}_2$ |
| 6H | $Q_2$ |

Timing Diagram Shows 0/0/0 being Shifted into the Shift Register. When $\emptyset_1$ is Low, $\emptyset_2$ and HOLD may be Brought High, thus Holding the Data Indefinitely. The Entire Shift Register may be Set or Cleared by Setting or Clearing the Input with $\emptyset_1$ and $\emptyset_2$ High and Hold Low. Enough Set/Reset Time must be Allowed for the Signal to Propagate the Entire Length of the Shift Register.

## Figure 6A - 6H

EP 0 204 034 B1

Figure 7A

22

*Figure 7B*

User I/O

| Micro-processor Micro-controller | → Address → → Control → ← Data → | CLA (Master) | CLA Data Clock → Data → | CLA (Slave 1) | Data → | CLA (Slave 2) | Data → | CLA (Slave N) |

User I/O

## Figure 8A

| Non-Volatile Memory (E$^2$ ROM, E PROM Etc. | → Addresses → ← Control → ← Data → | CLA (Master) | CLA Data Clock → Data → | CLA (Slave 1) | Data → | CLA (Slave 2) | Data → | CLA (Slave N) |

User I/O Lines

## Figure 8B

Z8002 SINGLE BOARD μC

Figure 9